# EUROPEAN PATENT SPECIFICATION

(11) **EP 3 651 561 B1**
(45) Date of publication and mention of the grant of the patent: **09.02.2022**
(21) Application number: 17916781.2
(22) Date of filing: 04.07.2017
(51) Int. Cl.: H05K 13/02, H01L 21/52, H05K 13/08, H05K 13/04, H01L 21/683

(54) **COMPONENT MOUNTING DEVICE**
KOMPONENTENMONTAGEVORRICHTUNG
DISPOSITIF DE MONTAGE DE COMPOSANT

(43) Date of publication of application: 13.05.2020
(73) Proprietor: Fuji Corporation, Chiryu-shi, Aichi 472-8686 (JP)
(72) Inventor: KAWAGUCHI, Koji, Chiryu-shi Aichi 472-8686 (JP)
(74) Representative: Grünecker Patent- und Rechtsanwälte PartG mbB
(86) International application number: PCT/JP2017/024510
(87) International publication number: WO 2019/008674

(56) References cited:
- EP-A1- 2 925 110
- EP-A1- 3 522 205
- WO-A1-2015/140888
- JP-A- H0 766 269
- JP-A- H01 109 737
- JP-A- 2008 300 437

## Description

### Technical Field

This specification discloses a component mounting device.

### Background Art

Conventionally, there has been proposed a component mounting system including a bonding head that uses a suction nozzle to pick up a component such as a pellet (die) adhered to an adhesive sheet and bond the component to a board while pressing the component, and a pushup unit that uses pusher pins to detach the component from the adhesive sheet by pushing up the component from the underside of the adhesive sheet (for example, refer to patent literature 1). In this component mounting system, the pushup unit measures the pushup load acting on the component in accordance with the pushup operation of the pusher pins, and the bonding head adjusts the pickup load acting on the component in accordance with the suction operation of the suction nozzle by feedback control based on the measured result of the pushup load.

Patent literature 2 is prior art pursuant to Article 54(3) EPC and discloses a component mounting device that uses suction nozzle to pick up a die that is a target for pickup from among dies affixed to die sheet while the die is being pushed up from underneath die sheet by pusher pin and mount the die on a target object. The component mounting device measures load applied to suction nozzle as the die D is being pushed up by the pusher pin in a state with the suction nozzle contacting the die, and determines that the die broke if the load decreases rapidly. The component mounting device, in a case in which the die breaks, lowers the pusher pin and the suction nozzle, and returns the broken die to its original position by supplying positive pressure to the suction nozzle.

Patent literature 3 proposes to provide a semiconductor manufacturing equipment which can be easily set and kept optimal in operating condition and enhanced in product manufacturing yield and availability. When a semiconductor chip is picked up from a wafer sheet by a collet, a load applied onto a needle which pushes up the rear of the wafer sheet is detected by a load cell provided to a load sensing section, and the state of the semiconductor chip is discriminated by a discriminating section basing on the detection signal. Therefore, an impact load corresponding to the state of the semiconductor chip is detected by a load detecting section, the detection signal and a discriminating reference waveform previously set and stored in a memory are compared with each other and discriminated through the discriminating section to discriminate the state of the semiconductor chip. A semiconductor manufacturing equipment of this design can be made to cope with the state of a semiconductor chip basing on the discrimination result, so that it can be easily set and kept optimal in operating condition and enhanced in product manufacturing yield and availability.

Patent literature 4 proposes to, while maintaining high efficiency mounting electronic circuit components to a circuit substrate, make it possible to avoid damage due to contact impact with a suction nozzle or circuit substrate. As well as rotating/raising/lowering axis being held on head main body as to be capable of rotation and of being raised/lowered, suction nozzle is not capable of being rotated and is capable of being raised/lowered relative to that rotating/raising/lowering axis. Suction nozzle is biased upwards with respect to rotating/raising/lowering axis by a biasing means. Also, raising/lowering driving member is held on head main body as to be capable of being raised/lowered, and is raised/lowered by first linear motor. As well as first engaging section of that raising/lowering driving member being engaged with rotating/raising/lowering axis, and second engaging section of second linear motor held on raising/lowering driving member being engaged with suction nozzle, and suction nozzle being raised/lowered together with rotating/raising/lowering axis; suction nozzle is lowered with respect to rotating/raising/lowering axis against the biasing force of a biasing means; and in that state component is mounted on a circuit substrate. Patent literature 5 proposes to provide an apparatus and a method for stably picking up a pick-up target, such as a semiconductor chip, at a high speed. This pick-up apparatus comprises a thrust-up unit and a pickup unit which face a mount therebetween, on which the pickup targets are arranged. The pickup unit comprises its body reciprocating in the direction of the mount by a driving means, and a suction portion provided on the body. The thrust-up unit comprises a pressure-detecting means, and a thrust-up pin to be subjected to reciprocating motion in the direction of the mount by a driving means. The contact pressure between the tip of the thrust-up pin and the pickup target is detected by the pressure-detecting means.

Patent literature 6 discloses a component mounting head is configured so as to comprise: a first raising and lowering device, which raises and lowers a nozzle retainer, which holds a suction nozzle, relative to a head main unit; a second raising and lowering device, which raises and lowers the suction nozzle relative to the nozzle retainer; an acting force detector, which detects acting force in the vertical direction acting on the suction nozzle; and a control device, which controls operation of the second raising and lowering device on the basis of the acting force detected by the acting force detector so that a force that has been set for a component is applied when mounting the component.

Patent literature 3 and 5 disclose component mounting devices according to the preamble of independent claim 1.

### Citation List

### Patent Literature

Patent literature 1: JP-A-2004-273910
Patent literature 2: EP 3 522 205 A1
Patent literature 3: JP H07 66269 A
Patent literature 4: EP 2 925 110 A1
Patent literature 5: JP 2008 300437 A
Patent literature 6: WO 2015/140888 A1

### Summary of Invention

### Technical Problem

However, in the above patent literature 1, during feedback control of a pickup load, if disturbance such as an impact load due to pushup of a pusher pin occurs, an excessive load may temporarily act on a component. In this case, the component may be damaged, such as cracks in the component or a portion of the component being broken.

A main object of the present disclosure is to appropriately separate multiple components from an adhesive sheet.

### Solution to Problem

The present invention according to claim 1 employs the following means to achieve the above object.

A component mounting device of the present disclosure is configured to collect a component that is one of multiple components adhered to a sheet and mount the component on a target object, the component mounting device comprising: a head; a pusher pin; a nozzle configured to collect the component; a raising and lowering device configured to raise and lower the nozzle relative to the head; a peeling device configured to peel the component to be collected by the nozzle from the sheet by pushing the component from an underside of the sheet using the pusher pin; a load measuring section configured to measure a load applied to the nozzle; and a control device configured to, in a state with the nozzle contacting the component, control the peeling device to raise the pusher pin to push the component up from the underside of the sheet, and control the raising and lowering device such that the load measured by the load measuring section is maintained within a specified load range,
characterized in that the raising and lowering device includes: a first raising and lowering device configured to raise and lower a raising and lowering member with respect to the head; and a second raising and lowering device configured to be raised and lowered together with the raising and lowering member by the first raising and lowering device, and configured to raise and lower the nozzle relative to the raising and lowering member, and the control device is further configured to control the first raising and lowering device and the second raising and lowering device such that the raising and lowering member is lowered to a position at which the nozzle contacts the component, then, in the state with the nozzle contacting the component, control the second raising and lowering device such that the load measured by the load measuring section is maintained within the specified load range, and control the first raising and lowering device such that the raising and lowering member rises in synchronization with the pusher pin rising when the pusher pin is raised.

A component mounting device of the disclosure is configured to collect a component that is one of multiple components adhered to a sheet and mount the component on a target object, the component mounting device including: a head; a nozzle, a first and second raising and lowering device; a peeling device; a load measuring section; and a control section. The control device is configured to, in a state with the nozzle contacting the component, control the peeling device to raise the pusher pin to push the component up from the underside of the sheet, control the second raising and lowering device such that the load measured by the load measuring section is held within a specified load range, and control the first raising and lowering device such that the raising and lowering member is raised when the pusher pin is raised. As a result, when the second raising and lowering device is

controlled such that the load is kept within a specified load range, the effect of disturbances such as an increase in the impact load due to the pusher pin of the peeling device being raised can be suppressed, such that load control can be performed with high accuracy. Accordingly, it is possible to prevent cracking or deformation from occurring in components adhered to the sheet, and to appropriately collect the components.

### Brief Description of Drawings

Fig. 1 is a configuration diagram showing an outline of the configuration of component mounting system 10.
Fig. 2 is a configuration diagram showing an outline of the configuration of mounting head 2.
Fig. 3 is a block diagram showing electrical connections of component mounting system 10.
Fig. 4 is a flow chart showing an example of processing during die pickup.
Fig. 5 illustrates states when suction nozzle 24 picks up die D adhered to die sheet 63.

### Description of Embodiments

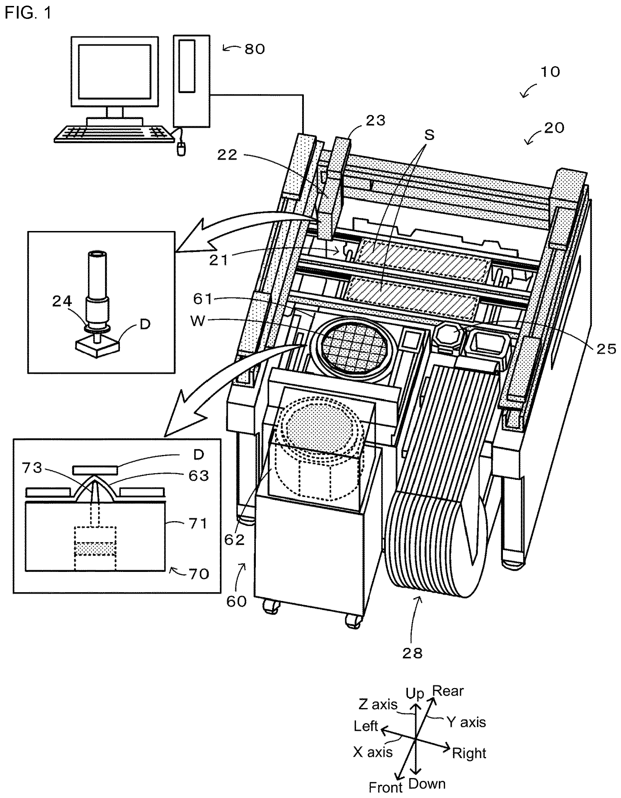

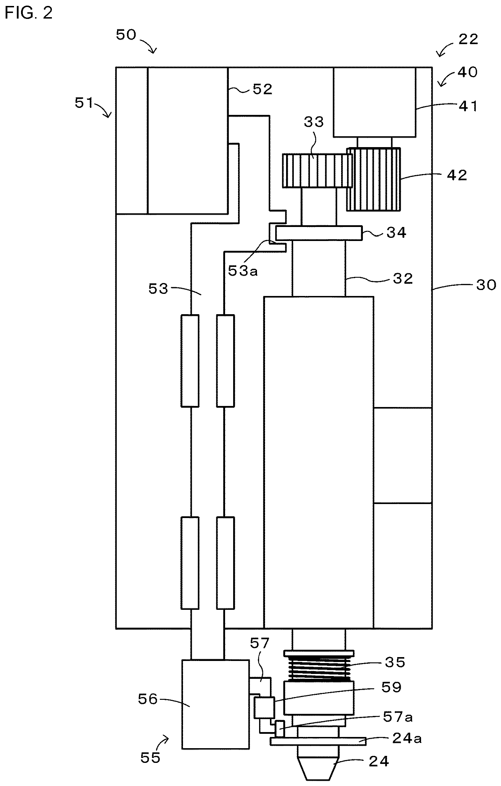

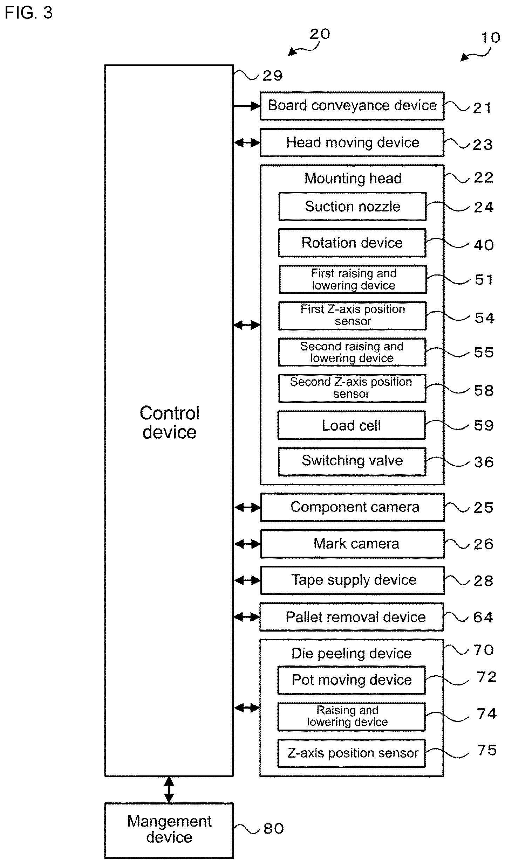

Embodiments of the present disclosure are described below with reference to the figures. Fig. 1 shows the overall configuration of component mounting system 10; fig. 2 shows the overall configuration of mounting head 22; fig. 3 is a block diagram showing electrical connections of mounting system 10. Note that, in fig. 1, the left-right direction is the X-axis direction, the front-rear direction is the Y-axis direction, and the up-down direction is the Z-axis direction.

As shown in fig. 1, component mounting system 10 is a system for mounting a component such as dies D divided on wafer W onto a target object (board S, another component, or the like), and is provided with component mounting device 20 and management computer (PC) 80. In component mounting system 10, multiple component mounting devices 20 that mount components on board S are arranged in a line from upstream to downstream. For convenience of description, fig. 1 only shows one component mounting device 20. Note that, component mounting system 10 may also be provided with items such as a solder printer, inspection machine, and reflow oven in the same mounting line as component mounting device 20.

Component mounting device 20 is provided with board conveyance device 21, mounting head 22, head moving device 23, suction nozzle 24, component camera 25, mark camera 26, tape supply device 28, wafer supply device 60, and control device 29. Board conveyance device 21 loads board S, conveys board S, fixes board S at a mounting position, and unloads board S. Board conveyance device 21 includes a pair of conveyor belts provided extending in a left-right direction and separated in the front-rear direction of fig. 1. Board S is conveyed by these conveyor belts.

Mounting head 22 is for picking up die D supplied from wafer supply device 60 or a component supplied from tape supply device 28 and mounting it on board S fixed by board conveyance device 21, and is moved in XY-axis directions by head moving device 23. Head moving device 23 is provided with sliders loaded on guide rails so as to slide in XY-axis directions, motors for driving the sliders, and position sensors for detecting the position of the sliders in the XY-axis directions.

As shown in fig. 2, mounting head 22 is provided with head main body 30, suction nozzle 24, rotation device 40, and raising and lowering device 50. At least one nozzle holder 32 is attached to mounting head 22 and suction nozzle 24 is removably attached to the lower end of nozzle holder 32. Suction nozzle 24 is attached to be movable in an up-down direction (Z-axis direction) with respect to nozzle holder 32. A compression spring, not shown, is built into nozzle holder 32 and suction nozzle 24 is biased upwards with respect to nozzle holder 32 by the biasing force of the compression spring. Rotation device 40 is provided with rotation motor 41 with gear 42 provided on rotation shaft thereof, and a rotation position sensor for detecting the rotation position of rotation motor 41. Gear 33 that engages with gear 42 is provided on the top end of nozzle holder 32, and nozzle holder 32 is movable in the Z-axis direction with respect to gear 42. Mounting head 22 can freely adjust the angle of nozzle holder 32 by driving rotation motor 41. Suction nozzle 24 is attached to nozzle holder 32, and mounting head 22 can adjust the angle of a component held by suction nozzle 24 by adjusting the angle of nozzle holder 32.

Raising and lowering device 50 includes first raising and lowering device 51 and second raising and lowering device 55. First raising and lowering device 51 is provided with first linear motor 52, first Z-axis slider 53 capable being raised and lowered in the Z-axis direction by the driving of first linear motor 52, and first Z-axis position sensor 54 that detects the position of first Z-axis slider 53 in the Z-axis direction. First engaging section 53a that can engage with (contact) horizontal section 34 provided on nozzle holder 32 is formed on first Z-axis slider 53. Therefore, suction nozzle 24 attached to nozzle holder 32 can be raised and lowered in accordance with the raising and lowering of first Z-axis slider 53.

Second raising and lowering device 55 is provided with second linear motor 56 attached to first Z-axis slider 53 of first raising and lowering device 51, and second Z-axis slider 57 that can be raised and lowered by the driving of second linear motor 56. Second engaging section 57a that can engage with (contact) an upper surface of flange section 24a that extends in a diameter direction at an upper section of suction nozzle 24 is formed on second Z-axis slider 57. Therefore, suction nozzle 24 can be raised and lowered in accordance with the raising and lowering of second Z-axis slider 57. In the present embodiment, the raising and lowering amount (stroke distance) of second Z-axis slider 57 by second raising and lowering device 55 is shorter than the raising and lowering amount of first Z-axis slider 53 by first raising and lowering device 51. Raising and lowering device 50, after roughly adjusting the Z-axis position of suction nozzle 24 using first raising and lowering device 51, finely adjusts the Z-axis position of suction nozzle 24 using second raising and lowering device 55. Also, load cell 59 for detecting load F applied to suction nozzle 24 when suction nozzle 24 picks up a component is provided on second Z-axis slider 57.

The suction opening of suction nozzle 24 is connected to a negative pressure source and a positive pressure source via switching valve 36 (electromagnetic valve), and by driving switching valve 36 a component is picked up by negative pressure being supplied to the suction opening and the component is released by applying positive pressure to the suction opening.

Component camera 25 is provided between board conveyance device 21 and tape supply device 28. Component camera 25 images a component held by suction nozzle 24 when suction nozzle 24 holding the component passes above component camera 25, and outputs the image to control device 29.

Mark camera 26 is provided on head moving device 23 to be movable in XY-axis directions. Mark camera 26 images from above positioning reference marks provided on board S for recognizing the position of board S as it is conveyed, and outputs an image of the reference marks to control device 29. Also, mark camera 26 images from above wafer W that includes dies D to be picked up by mounting head 22, and sends the image to control device 29.

Tape supply device 28 is provided with a reel around which tape storing components is wound, and supplies components to component mounting device 20 by pulling the tape from the reel.

Wafer supply device 60 is for supplying dies D divided on wafer W to a pickup position of mounting head 22 and is provided with wafer pallet 61, magazine 62, and die peeling device 70. Die sheet 63 to which wafer W is affixed is attached to wafer pallet 61 in a stretched state. Multiple wafer pallets 61 are stored in magazine 62, and a wafer pallet 61 is pulled out from magazine 62 by pallet removal device 64 when die D is to be picked up by mounting head 22.

Die peeling device 70 is provided with pot 71, pot moving device 72, pusher pin 73 (pushing section), and raising and lowering device 74. Pot 71 is arranged below wafer pallet 61 removed by pallet removal device 64, and is movable in the XY-axis directions via pot moving device 72. Pot moving device 72 is provided with sliders loaded on guide rails so as to slide in XY-axis directions, linear motors for driving the sliders, and position sensors for detecting the position of the sliders in the XY-axis directions. Pusher pin 73 is arranged inside pot 71 that is raised and lowered by the driving of a linear motor, and is for pushing up die D from underneath die sheet 63, the die D being the die D to be picked up among the dies D divided on wafer W affixed to die sheet 63. Multiple types of pusher pins 73 of a different quantity and size are provided in accordance with the size of die D. Die peeling device 70 is provided with multiple pots 71 that include different types of pusher pins 73, and by selecting a pot 71 in accordance with the size of the die D, the die can be pushed. A suction opening is provided on an upper surface of pot 71, and die peeling device 70 is able to push up and peel only the die D to be picked up die sheet 63 by pusher pin 73 pushing up the die in a state with the upper surface of pot 71 suctioning and supporting die sheet 63.

Raising and lowering device 74 is configured to raise and lower pot 71 and pusher pin 73, and when the upper surface of pot 71 approaches a position just about contacting die sheet 63, the raising of pot 71 is stopped by a stopper mechanism, which is not shown, then, pusher pin 73 protrudes from the upper surface of pot 71, and die D is pushed from underneath die sheet 63.

Control device 29 is configured from a microprocessor built around a CPU, and is provided with ROM, RAM, an input and output board, and the like. As shown in fig. 3, control device 29 receives signals from mounting head 22 (first Z position sensor 54, and second Z-axis position sensor 58, load cell 59, and a rotation position sensor), head moving device 23 (position sensor), component camera 25, mark camera 26, tape supply device 28, pallet removal device 64, and die peeling device 70 (Z-axis position sensor 75) via an input port. Also, control device 29 outputs signals to board conveyance device 21, mounting head 22 (first raising and lowering device 51, second raising and lowering device 55, rotation device 40, switching valve 36), component camera 25, mark camera 26, tape supply device 28, pallet removal device 64, and die peeling device 70 (pot moving device 72 and raising and lowering device 74) via an output port.

Management PC 80 is connected to control device 29 such that communication is possible and manages items such as job information. Job information includes, for example, the mounting order of components, the sizes and types of components to be mounted, devices to be used, the size of board S, the production quantity, and so on.

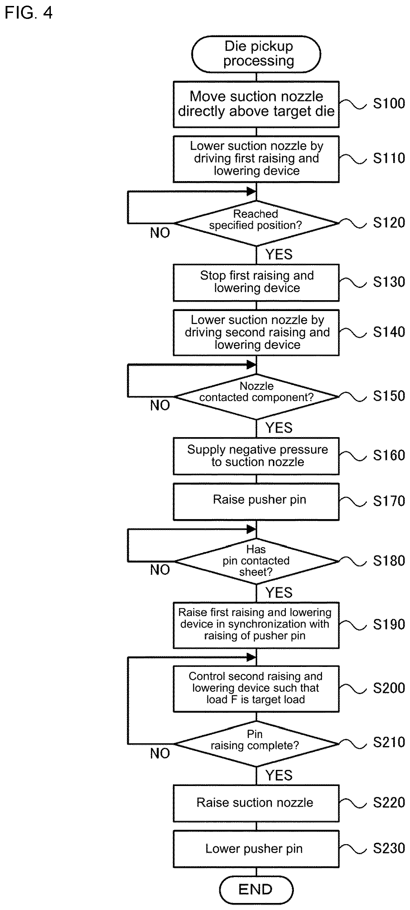

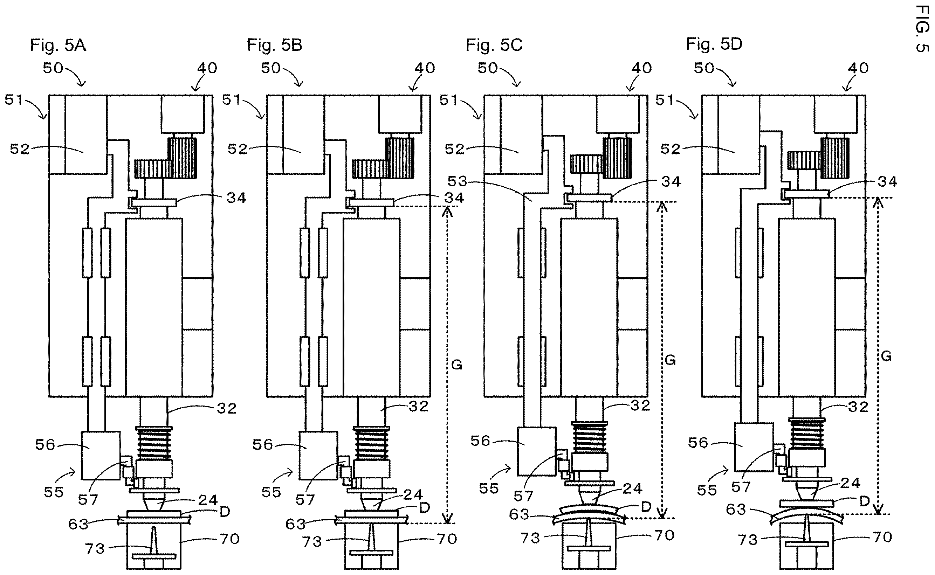

Next, operation of component mounting system 10 of an embodiment configured as above is described, in particular, operation of picking up die D using suction nozzle 24 when performing operation of picking up die D from wafer W and mounting the die D on a target object. Figs. 4 and 5 are a flowchart and diagrams showing an example of processing during die pickup performed by control device 29. This processing is performed when a production command including job information is received from management PC 50.

During die mounting processing, control device 29, first, performs drive control of head moving device 23 such that suction nozzle 24 is moved directly above the die D to be picked up (target die) (S100). Next, control device 29 controls first raising and lowering device 51 to lower suction nozzle 24 at high speed (S110). Then, control device 29 determines whether the Z-axis direction position of suction nozzle 24 identified based on signals from first Z-axis position sensor 54 and second Z-axis position sensor 58 has reached the specified position (S120). Here, the specified position is defined as a position a predetermined distance ahead of the position where suction nozzle 24 contacts die D.

Control device 29, if determining that the position of suction nozzle 24 has not reached the specified position, continues lowering suction nozzle 24 using first raising and lowering device 51, and if determining that the position of suction nozzle 24 has reached the specified position, stops driving first raising and lowering device 51 (step S130) and further lowers suction nozzle 24 at low speed by performing drive control of second raising and lowering device 55 (step S140). Further, control device 29 determines whether suction nozzle 24 has contacted the target die (component) (S150). This processing, for example, may be performed by determining whether load F applied to suction nozzle 24 that is detected by load cell 59 exceeds a specified load.

Control device 29, if determining that suction nozzle 24 has not contacted the target die, continues lowering suction nozzle 24, and if determining that suction nozzle 24 has contacted the target die, performs drive control of switching valve 36 to supply negative pressure to the suction opening of suction nozzle 24 (step S160) and then performs drive control of raising and lowering device 74 of die peeling device 70 to push up the target die from underneath die sheet 63 (step S170), then determines whether pusher pin 73 has contacted die sheet 63 (S180). Here, it is assumed that pusher pin 73 stands by at a height position slightly separated from the underside surface of die sheet 63. Further, processing of S180 may also be determined, for example, based on a degree to which load F acting on the suction nozzle 24 increases as detected by load cell 59. Control device 29, upon determining that pusher pin 73 has not contacted die sheet 63, continues raising pusher pin 73 while stopping the driving of first raising and lowering device 51, and upon determining that pusher pin 73 has contacted die sheet 63, in synchronization with the raising of pusher pin 73, performs drive control to raise first raising and lowering device 51. Note that, pusher pin 73 contacting die sheet 63 pushes up the target die from the underside of die sheet 63. By performing drive control to raise first raising and lowering device 51 in synchronization with the raising of pusher pin 73 in S190, control device 29 is able to maintain the interval between horizontal section 34 of nozzle holder 32 that engages with first Z-axis slider 53 and the pushup position (position of leading end) of pusher pin 73 at a substantially fixed interval. Therefore, it is possible to suppress an excessive impact load or the like from acting on suction nozzle 24 due to the target die being pushed up by pusher pin 73.

Then, control device 29 continues drive control of second raising and lowering device 55 using feedback control such that load F applied to suction nozzle 24 remains at target load F1 (step S200), and determines whether the pushing of the target die is complete and whether peeling of the target die is complete (step S210). In the present embodiment, by performing drive control such that first raising and lowering device 51 rises in synchronization with the raising of pusher pin 73, it is possible to perform the drive control of S200 with high accuracy because the effects of disturbances are appropriately eliminated by suppressing the excessive impact load or the like from acting on suction nozzle 24. Therefore, it is possible to prevent the target die from cracking or the like by preventing excessive stresses from acting on the target die by the drive control of second raising and lowering device 55. On the other hand, control device 29, if determining that pushing of the target die by pusher pin 73 is complete in S210, performs drive control of first raising and lowering device 51 and second raising and lowering device 55 to raise suction nozzle 24 and pick up the target die (step S220), lowers pusher pin 73 (S230), and ends processing during die pickup. Note that, upon the target die being picked up by suction nozzle 24 in this manner, control device 29 passes the target die picked up by suction nozzle 24 above component camera 25, captures an image with component camera 25, and processes the obtained image to correct the target mounting position on board S. Then, control device 29 performs drive control of head moving device 23 to move the target die directly above the target mounting position, and performs drive control of first raising and lowering device 51 and second raising and lowering device 55 to lower suction nozzle 24 to mount the target die on board S. Note that, control device 29 mounts the target die such that the load F acting on suction nozzle 24 is an appropriate pressing load for mounting the target die on board S.

Fig. 5 illustrates states when suction nozzle 24 picks up die D adhered to die sheet 63. Control device 29, upon controlling second raising and lowering device 55 of mounting head 22 such that suction nozzle 24 contacts die D (see fig. 5A), performs drive control of raising and lowering device 74 of die peeling device 70 to raise pusher pin 73. Then, when pusher pin 73 contacts the underside of die sheet 63 (see fig. 5B), die D is pushed up from the underside of die sheet 63 by the raising of pusher pin 73. While die D is being pushed up by pusher pin 73, control device 29 performs drive control of second raising and lowering device 55 by feedback control such that load F acting on suction nozzle 24 becomes the target load. Further, in synchronization with the pushup of pusher pin 73, control device 29 performs drive control of first raising and lowering device 51 such that first Z-axis slider 53 moves up and down (refer to figs. 5C and D). That is, control device 29 performs drive control of linear motor 52 of first Z-axis slider 53 in synchronization with the drive control of the linear motor for raising pusher pin 73. As a result, the pushup amount (raising amount) of die D due to the raising of pusher pin 73 can be absorbed by first Z-axis slider 53 of first raising and lowering device 51, such that the interval G between horizontal section 34 of nozzle holder 32 that engages with first Z-axis slider 53 and the raising position (leading end position) of pusher pin 73 can be maintained at a substantially fixed interval. Accordingly, it is possible to suppress an excessive impact load or the like from acting on suction nozzle 24 as the die D is pushed up, and to perform feedback control with high accuracy so that load F acting on suction nozzle 24 becomes the target load. Thus, cracking of the die D due to excessive stresses can be prevented, and the die D can be appropriately picked up.

Next, correspondences between constituent elements of the present embodiment and constituent elements of the disclosure will be clarified. Mounting head 22 of the present embodiment corresponds to a head of the disclosure, suction nozzle 24 corresponds to a nozzle, first raising and lowering device 51 corresponds to a first raising and lowering device, second raising and lowering device 55 corresponds to a second raising and lowering device, die peeling device 70 corresponds to a peeling device, load cell 59 corresponds to a load measuring unit, and control device 29 corresponds to a control device.

The component mounting device 20 of the present embodiment described above includes first raising and lowering device 51 for raising and lowering first Z-axis slider 53, and second raising and lowering device 55 for raising and lowering first Z-axis slider 53 and raising and lowering suction nozzle 24 with respect to first Z-axis slider 53. Further, component mounting device 20 picks up die D adhered to die sheet 63 using suction nozzle 24 while pushing up the die D from the underside of die sheet 63 using pusher pin 73 and uses feedback control such that load F acting on suction nozzle 24 becomes the target load. Also, when die D is being pushed up by pusher pin 73, drive control of first raising and lowering device 51 is performed to raise and lower first Z-axis slider 53. As a result, when feedback control is performed such that load F becomes the target load, the influence of disturbances such as an increase in the impact load due to the raising of pusher pin 73 can be suppressed, such that load control can be performed with high accuracy. For this reason, it is possible to prevent cracks or the like from occurring in the die D adhered to die sheet 63 and to appropriately perform collection of the die.

In addition, when pusher pin 73 is raised, since component mounting device 20 performs drive control of first raising and lowering device 51 such that first Z-axis slider 53 is raised in synchronization with the raising of pusher pin 73, it is possible to more appropriately suppress the influence of disturbances caused by the raising of pusher pin 73 and perform load control with higher accuracy.

Further, component mounting device 20 is able to make the raising and lowering amount of second Z-axis slider 57 by second raising and lowering device 55 smaller than the raising and lowering amount of first Z-axis slider 53 by first raising and lowering device 51. By raising first Z-axis slider 53 when raising pusher pin 73, suction nozzle 24 can appropriately follow the raising of die D, such that the amount of raising and lowering of second Z-axis slider 57 of second raising and lowering device 55 does not need to be increased unnecessarily.

Component mounting device 20 raises first Z-axis slider 53 in accordance with the raising of pusher pin 73 after pusher pin 73 contacts the underside of die sheet 63 having been raised from the separated position separated from the underside of die sheet 63. Thus, since first Z-axis slider 53 can be raised in accordance with the raising of pusher pin 73 while die D is securely sandwiched between suction nozzle 24 and pusher pin 73, die D can be appropriately peeled from die sheet 63 while more reliably curtailing damage to die D during pushup of die D.

Meanwhile, it goes without saying that the invention is not limited to the above-mentioned embodiment and various embodiments may be applied within the technical scope of the invention within the limits as defined by the appended claims.

For example, in an embodiment described above, first Z-axis slider 53 is raised in synchronization with the raising of pusher pin 73 after pusher pin 73 has contacted the underside of die sheet 63 having been raised from the separated position separated from the underside of die sheet 63, but the configuration is not limited thereto. For example, control device 29 may control first raising and lowering device 51 to raise first Z-axis slider 53 in synchronization with the raising of pusher pin 73 prior to pusher pin 73 coming into contact with the underside of die sheet 63.

In an embodiment described above, suction nozzle 24 contacts the upper surface of die D while pusher pin 73 is standing by at the separated position separated from the underside of die sheet 63, but the configuration is not limited thereto. For example, control device 29 may bring suction nozzle 24 into contact with the upper surface of die D while pusher pin 73 is standing by in a contact position contacting the underside of die sheet 63. In this case, control device 29 may control first raising and lowering device 51 to raise first Z-axis slider 53 such that suction nozzle 24 contacts the upper surface of die D in synchronization with the starting of the raising of pusher pin 73.

In an embodiment described above, drive control is performed on first raising and lowering device 51 such that first Z-axis slider 53 is raised in synchronization with the raising of pusher pin 73 by driving linear motor 52 of first Z-axis slider 53 in synchronization with the driving of the linear motor for raising pusher pin 73, but the configuration is not limited thereto. That is, the configuration is not limited to one in which the raising of first Z-axis slider 53 is always synchronized with the raising of pusher pin 73, and drive control may be performed of first raising and lowering device 51 such that first Z-axis slider 53 is raised when pusher pin 73 is raised. In this case, drive control of first raising and lowering device 51 may be performed such that first Z-axis slider 53 rises to such an extent that the influence of disturbances such as an impact load due to the raising of pusher pin 73 can be suppressed. However, in order to appropriately suppress the influence of disturbances, it is desirable to synchronize the raising of first Z-axis slider 53 with the raising of pusher pin 73.

Further, component mounting device 20 is configured such that the raising amount of second Z-axis slider 57 by second raising and lowering device 55 is smaller than the raising amount of first Z-axis slider 53 by first raising and lowering device 51.

In an embodiment described above, mounting head 22 is provided with load cell 59 for measuring load F acting on suction nozzle 24, but the load acting on suction nozzle 24 may be measured by detecting or estimating the load current of second linear motor 56.

The disclosed component mounting device may be configured as follows.

In the disclosed component mounting device, when the pusher pin is raised, the control device may control the first raising and lowering device such that the raising and lowering member is raised in synchronization with the raising of the pusher pin. This makes it possible to more appropriately suppress the influence of disturbances such as an increase in impact load due to raising of the pusher pin, enabling load control to be performed with higher accuracy.

In the disclosed component mounting device, the second raising and lowering device may make the relative raising and lowering amount of the nozzle with respect to the raising and lowering member smaller than the relative raising and lowering amount of the raising and lowering member with respect to the head by the first raising and lowering device. By controlling the first raising and lowering device such that the raising and lowering member is raised when the pusher pin is raised, the nozzle can appropriately follow the pushing up of the component, such that the raising and lowering amount of the second raising and lowering device does not need to be increased unnecessarily.

In the disclosed component mounting device, the peeling device may be configured such that the pusher pin stands by at a separated position separated from the underside of the sheet when the raising and lowering member is lowered to the position where the nozzle contacts the component, the pusher pin being raised from the separated position, and the control device may be configured to control the first raising and lowering device such that the raising and lowering member is raised in accordance with the raising of the pusher pin after the pusher pin has contacted the underside of the sheet having been raised from the separated position. In this manner, since the raising and lowering member can be raised in accordance with the raising of the pusher pin while the component is securely sandwiched between the nozzle and the pusher pin, the component can be appropriately peeled from the sheet while damage to the component during pushing up is more reliably curtailed.

### Industrial applicability

The present invention may be applied to the industrial field of component mounting devices and the like.

### Reference Signs List

- 10:: component mounting system;
- 20:: component mounting device;
- 21:: board conveyance device;
- 22:: mounting head;
- 23:: head moving device;
- 24:: suction nozzle;
- 24a:: flange section;
- 25:: component camera;
- 26:: mark camera;
- 28:: tape supply device;
- 30:: head main body;
- 32:: nozzle holder;
- 33:: gear;
- 34:: horizontal section;
- 36:: switching valve;
- 40:: rotation device;
- 41:: rotation motor;
- 42:: gear;
- 50:: raising and lowering device;
- 51:: first raising and lowering device;
- 52:: first linear motor;
- 53:: first Z-axis slider;
- 53a:: first engaging section;
- 54:: first Z-axis position sensor;
- 55:: second raising and lowering device;
- 56:: second linear motor;
- 57:: second Z-axis slider;
- 57a:: second engaging section;
- 58:: second Z-axis position sensor;
- 59:: load cell;
- 60:: wafer supply device;
- 61:: wafer pallet;
- 62:: magazine;
- 63:: die sheet;
- 64:: pallet removal device;
- 70:: die peeling device;
- 71:: pot;
- 72:: pot moving device;
- 73:: pusher pin;
- 74:: raising and lowering device;
- 75:: Z-axis position sensor;
- 80:: management computer (PC);
- D:: die;
- S:: board;
- W:: wafer

## Claims

1. A component mounting device (20) configured to collect a component (D) that is one of multiple components (D) adhered to a sheet (63) and mount the component (D) on a target object, the component mounting device (20) comprising:
a head (22);
a pusher pin (73);
a nozzle (24) configured to collect the component (D):
a raising and lowering device (50) configured to raise and lower the nozzle (24) relative to the head (22);
a peeling device (70) configured to peel the component (D) to be collected by the nozzle (24) from
the sheet (63) by pushing the component (D) from an underside of the sheet (63) using the pusher
pin (73);
a load measuring section (59) configured to measure a load applied to the nozzle (24); and a control device (29) configured to, in a state with the nozzle (24) contacting the component (D), control the peeling device (70) to raise the pusher pin (73) to push the component (D) up from the underside of the sheet (63), and control the raising and lowering device (50) such that the load measured by the load measuring section (59) is maintained within a specified load range,
**characterized in that**
the raising and lowering device (50) includes:
a first raising and lowering device (51) configured to raise and lower a raising and lowering member (53) with respect to the head (22); and
a second raising and lowering device (55) configured to be raised and lowered together with the raising and lowering member (53) by the first raising and lowering device (51), and configured to raise and lower the nozzle (24) relative to the raising and lowering member (53), and
the control device (29) is further configured to control the first raising and lowering device (51) and the second raising and lowering device (55) such that the raising and lowering member (53) is lowered to a position at which the nozzle (24) contacts the component (D), then, in the state with the nozzle (24) contacting the component (D), control the second raising and lowering device (55) such that the load measured by the load measuring section (59) is maintained within the specified load range, and control the first raising and lowering device (51) such that the raising and lowering member (53) rises in synchronization with the pusher pin (73) rising when the pusher pin (73) is raised.

2. The component mounting device (20) according to claim 1, wherein
the second raising and lowering device (55) is configured such that a relative raising and lowering amount of the nozzle (24) with respect to the raising and lowering member (53) is less than a raising and lowering amount of the raising and lowering member (53) with respect to the head (22) by the first raising and lowering device (51).

3. The component mounting device (20) according to claims 1 or 2, wherein
the peeling device (70) is configured such that the pusher pin (73) stands by at a separated position separated from the underside of the sheet (63) when the raising and lowering member (53) is lowered to the position where the nozzle (24) contacts the component (D), the pusher pin (73) being raised from the separated position, and
the control device (29) is configured to control the first raising and lowering device (51) such that the raising and lowering member (53) is raised in accordance with the raising of the pusher pin (73) after the pusher pin (73) has contacted the underside of the sheet (63) having been raised from the separated position.

## Patentansprüche

1. Eine Komponentenmontagevorrichtung (20), die konfiguriert ist, um eine Komponente (D), die eine von mehreren Komponenten (D) ist, die an einem Blatt (63) haften, zu sammeln und die Komponente (D) an einem Zielobjekt zu montieren, die Komponentenmontagevorrichtung (20) umfasst:
einen Kopf (22);
einen Druckstift (73);
eine Düse (24), die konfiguriert ist, um die Komponente (D) zu sammeln;
eine Hebe- und Senkvorrichtung (50), die konfiguriert ist, um die Düse (24) relativ zum Kopf (22) anzuheben und abzusenken;
eine Abziehvorrichtung (70), die konfiguriert ist, um die durch die Düse (24) zu sammelnde Komponente (D) unter Verwendung des Schiebestifts (73) von dem Blatt (63) durch Drücken der Komponente (D) von einer Unterseite des Blattes (63), abzuziehen;
einen Lastmessabschnitt (59), der konfiguriert ist, um eine auf die Düse (24) aufgebrachte Last zu messen; und
eine Steuervorrichtung (29), die konfiguriert ist, um in einem Zustand, in dem die Düse (24) die Komponente (D) berührt, die Abziehvorrichtung (70) zu steuern, um den Druckstift (73) anzuheben, um die Komponente (D) von der Unterseite des Blattes (63) nach oben zu drücken und die Hebe- und Senkvorrichtung (50) so steuern, dass die von dem Lastmessabschnitt (59) gemessene Last innerhalb eines spezifizierten Lastbereichs gehalten wird,
**gekennzeichnet dadurch dass**
die Hebe- und Senkvorrichtung (50) beinhaltet:
eine erste Hebe- und Senkvorrichtung (51), die konfiguriert ist, um ein Hebe- und Senkelement (53) in Bezug auf den Kopf (22) anzuheben und abzusenken; und
eine zweite Hebe- und Senkvorrichtung (55), die konfiguriert ist, um zusammen mit dem Hebe- und Senkelement (53) durch die erste Hebe- und Senkvorrichtung (51) angehoben und abgesenkt zu werden, und die konfiguriert ist, um die Düse (24) relativ zu der Hebe- und Senkelement (53) anzuheben und abzusenken, und
die Steuervorrichtung (29) ferner dazu konfiguriert ist, die erste Hebe- und Senkvorrichtung (51) und die zweite Hebe- und Senkvorrichtung (55) so zu steuern, dass das Hebe- und Senkelement (53) in eine Position abgesenkt wird, an der die Düse (24) die Komponente (D) berührt, dann in dem Zustand, in dem die Düse (24) die Komponente (D) berührt, die zweite Hebe- und Senkvorrichtung (55) so zu steuern, dass die von der Lastmessstrecke (59) gemessene Last innerhalb des spezifizierten Lastbereichs gehalten wird, und die erste Hebe- und Senkvorrichtung (51) so zu steuern, dass das Hebe- und Senkelement (53) synchron mit dem Anheben des Druckstifts (73) angehoben wird, wenn der Druckstift (73) angehoben wird.

2. Die Komponentenmontagevorrichtung (20) gemäß Anspruch 1, wobei
die zweite Anhebe- und Absenkvorrichtung (55) so konfiguriert ist, dass ein relativer Anhebe- und Absenkbetrag der Düse (24) in Bezug auf das Anhebe- und Absenkelement (53) geringer ist als ein Anhebe- und Absenkbetrag des Anhebe- und Absenkelements (53) gegenüber dem Kopf (22) durch die erste Hebe- und Senkvorrichtung (51).

3. Die Komponentenmontagevorrichtung (20) gemäß Anspruch 1 oder 2, wobei
die Abziehvorrichtung (70) so konfiguriert ist, dass der Druckstift (73) an einer von der Unterseite des Blattes (63) separierten Position bereitsteht, wenn das Hebe- und Senkelement (53) in die Position abgesenkt wird, in der die Düse (24) die Komponente (D) berührt, wobei der Druckstift (73) aus der separierten Position angehoben wird, und
die Steuervorrichtung (29) konfiguriert ist, um die erste Hebe- und Senkvorrichtung (51) so zu steuern, dass das Hebe- und Senkelement (53) in Übereinstimmung mit dem Anheben des Druckstifts (73) angehoben wird nachdem der Druckstift (73), der aus der separierten Position angehoben wurde, die Unterseite des Blattes (63) berührt hat.

## Revendications

1. Dispositif de montage de composant (20) configuré pour recueillir un composant (D) qui est l'un parmi plusieurs composants (D) collés à une feuille (63) et monter le composant (D) sur un objet cible, le dispositif de montage de composant (20) comprenant :
une tête (22) ;
une goupille de poussée (73) ;
une buse (24) configurée pour recueillir le composant (D) :
un dispositif de levage et d'abaissement (50) configuré pour lever et abaisser la buse (24) par rapport à la tête (22) ;
un dispositif de décollement (70) configuré pour décoller le composant (D) à recueillir par la buse (24) à partir de la feuille (63) en poussant le composant (D) depuis une partie inférieure de la feuille (63) en utilisant la goupille de poussée (73) ;
une section de mesure de charge (59) configurée pour mesurer une charge appliquée à la buse (24) ; et
un dispositif de commande (29) configuré pour, dans un état où la buse (24) est en contact avec le composant (D), commander au dispositif de décollement (70) de lever la goupille de poussée (73) pour pousser le composant (D) vers le haut depuis la partie inférieure de la feuille (63), et commander le dispositif de levage et d'abaissement (50) de manière que la charge mesurée par la section de mesure de charge (59) est maintenue dans une plage de charges spécifiée,
**caractérisé en ce que**
le dispositif de levage et d'abaissement (50) inclut :
un premier dispositif de levage et d'abaissement (51) configuré pour lever et abaisser un élément de levage et d'abaissement (53) par rapport à la tête (22) ; et
un second dispositif de levage et d'abaissement (55) configuré pour être levé et abaissé conjointement à l'élément de levage et d'abaissement (53) par le premier dispositif de levage et d'abaissement (51), et configuré pour lever et abaisser la buse (24) par rapport à l'élément de levage et d'abaissement (53), et
le dispositif de commande (29) est configuré en outre pour commander le premier dispositif de levage et d'abaissement (51) et le second dispositif de levage et d'abaissement (55) de manière que l'élément de levage et d'abaissement (53) est abaissé à une position à laquelle la buse (24) entre en contact avec le composant (D), ensuite, dans l'état où la buse (24) entre en contact avec le composant (D), commander le second dispositif de levage et d'abaissement (55) de manière que la charge mesurée par la section de mesure de charge (59) est maintenue dans la plage de charges spécifiée, et commander le premier dispositif de levage et d'abaissement (51) de manière que l'élément de levage et d'abaissement (53) s'élève en synchronisation avec l'élévation de la goupille de poussée (73) lorsque la goupille de poussée (73) est levée.

2. Dispositif de montage de composant (20) selon la revendication 1, dans lequel
le second dispositif de levage et d'abaissement (55) est configuré de manière qu'une quantité relative de levage et d'abaissement de la buse (24) par rapport à l'élément de levage et d'abaissement (53) est inférieure à une quantité de levage et d'abaissement de l'élément de levage et d'abaissement (53) par rapport à la tête (22) par le premier dispositif de levage et d'abaissement (51).

3. Dispositif de montage de composant (20) selon les revendications 1 ou 2, dans lequel
le dispositif de décollement (70) est configuré de manière que la goupille de poussée (73) se trouve à une position séparée qui est séparée de la partie inférieure de la feuille (63) lorsque l'élément de levage et d'abaissement (53) est abaissé à la position où la buse (24) entre en contact avec le composant (D), la goupille de poussée (73) étant levée depuis la position séparée, et
le dispositif de commande (29) est configuré pour commander le premier dispositif de levage et d'abaissement (51) de manière que l'élément de levage et d'abaissement (53) est levé en fonction du levage de la goupille de poussée (73) après que la goupille de poussée (73) est entrée en contact avec la partie inférieure de la feuille (63) qui a été levée depuis la position séparée.
